# EUROPÄISCHE PATENTANMELDUNG

(11) **EP 2 485 285 A2**
(43) Veröffentlichungstag der Anmeldung: **08.08.2012**
(21) Anmeldenummer: 12166424.7
(22) Anmeldetag: 26.04.2001
(51) Int. Cl.: H01L 33/50, H01L 33/48

(54) **Strahlungsemittierendes Halbleiterbauelement mit Lumineszenzkonversionselement**

(30) Priorität: 26.04.2000 DE 10020465
(62) Teilanmeldung aus: 01940201.5
(71) Anmelder: Osram Opto Semiconductors Gmbh, 93055 Regensburg (DE)
(72) Erfinder: Brunner, Herbert, 93161 Sinzing (DE); Debray, Alexandra, 91058 Erlangen (DE); Jäger, Harald, 93049 Regensburg (DE); Waitl, Günter, 93049 Regensburg (DE)
(74) Vertreter: Epping - Hermann - Fischer

(57) **Zusammenfassung**

Die Erfindung beschreibt ein strahlungsemittierendes Halbleiterbauelement mit Lumineszenzkonversionselement (7), bei dem der Halbleiterkörper (3) in einer Ausnehmung des Grundkörpers (1) angeordnet ist. Innerhalb der Ausnehmung ist um den Halbleiterkörper ist ein napfartiger Bereich ausgeformt, der das Lumineszenzkonversionselement (7) enthält und das den Halbleiterkörper (3) einhüllt. Der napfartige Bereich ist als Vertiefung innerhalb der Ausnehmung oder als ringförmige Einfassung (6) auf dem Grund der Ausnehmung geformt.

## Beschreibung

Die Erfindung bezieht sich auf ein strahlungsemittierendes Halbleiterbauelement sowie ein Herstellungsverfahren hierfür.

Stahlungsemittierende Halbleiterbauelemente sind beispielsweise aus WO 97/50132 bekannt. Solche Bauelemente enthalten einen Halbleiterkörper, der im Betrieb Licht aussendet (Primärlicht) und ein Lumineszenzkonversionselement, das einen Teil dieses Lichts in einen anderen Wellenlängenbereich konvertiert (Fluoreszenzlicht). Der Gesamtfarbeindruck des von einem solchen Halbleiterbauelement emittierten Lichts ergibt sich durch additive Farbmischung aus Primärlicht und Fluoreszenzlicht.

Häufig wird als Lumineszenzkonversionselement ein Leuchtstoff verwendet, der in einem Kunstharz suspendiert ist. Wie in WO 97/50132 gezeigt ist, besteht eine Bauform von strahlungsemittierenden Halbleiterbauelementen darin, den Halbleiterkörper in einer Ausnehmung des Bauelementgrundkörpers anzuordnen und diese Ausnehmung mit der Leuchtstoffsuspension zu füllen.

Diese Anordnung besitzt den Nachteil, daß die Quellen von Primärlicht - Halbleiterkörper - und von Fluoreszenzlicht - Leuchtstoffsuspension - im allgemeinen von verschiedener Form und Größe sind, so daß je nach Abstrahlrichtung eine Aufspaltung in verschiedene Farbanteile erfolgt und ein räumlich inhomogener Farbeindruck entsteht. Bei optischen Abbildungen treten starke chromatische Fehler auf.

Ein weiterer Nachteil besteht darin, daß der Farbeindruck von der optischen Weglänge in der Suspension abhängt, so daß fertigungsbedingte Schwankungen der Dicke der Suspensionsschicht über dem Halbleiterkörper zu verschiedenen Farbeindrücken führen. Ferner ist grundsätzlich eine sehr gleichmäßige Verteilung des Leuchtstoffs in der Suspension nötig.

Der vorliegenden Erfindung liegt die Aufgabe zugrunde, ein strahlungsemittierendes Halbleiterbauelement der eingangs genannten Art zu entwickeln, das homogen mischfarbiges Licht abstrahlt. Weiterhin ist es Aufgabe der vorliegenden Erfindung, ein Herstellungsverfahren für solche Bauelemente zu schaffen.

Diese Aufgabe wird durch ein Halbleiterbauelement nach Patentanspruch 1 sowie ein Verfahren nach Patentanspruch 11 beziehungsweise 12 gelöst. Vorteilhafte Weiterbildungen der Erfindung sind Gegenstand der abhängigen Ansprüche.

Erfindungsgemäß ist vorgesehen, den Grundkörper des Halbleiterbauelements so auszuführen, daß in der zur Aufnahme des Halbleiterkörpers gebildeten Ausnehmung in der unmittelbaren Umgebung des Halbleiterkörpers ein gesonderter, napfförmiger Bereich ausgeformt ist, der das Lumineszenzkonversionselement enthält. Gegenüber einer großvolumigen, die gesamte Ausnehmung füllenden Umhüllung des Halbleiterkörpers mit dem Lumineszenzkonversionselement besitzt diese Anordnung den Vorteil, daß das Fluoreszenzlicht aus nahezu demselben Volumen wie das Primärlicht abgestrahlt wird, wodurch ein besonders gleichmäßiger Farbeindruck entsteht.

Bei einer besonders bevorzugten Ausführungsform ist der gesonderte Bereich zur Aufnahme des Lumineszenzkonversionselements durch eine Vertiefung innerhalb der Ausnehmung geformt. Eine weitere besonders bevorzugte Ausführungsform besteht darin, den gesonderten Bereich durch eine ringförmige Einfassung auf dem Grund der Ausnehmung auszubilden. Bei beiden Ausführungsformen können mit großem Vorteil Gehäuse mit Standardformen als Grundkörper verwendet werden. Vorteilhafterweise sind die Seitenflächen der Vertiefung beziehungsweise der ringförmigen Einfassung so geformt, daß die Seitenflächen als Reflektor für die erzeugte Strahlung dienen und so die Strahlungsausbeute erhöht wird.

Eine vorteilhafte Weiterbildung der Erfindung besteht darin, daß in den Grundkörper ein Leiterrahmen so eingebettet ist, daß ein Teil des Leiterrahmens die Bodenfläche der Vertiefung bei der einen oben beschriebenen Ausführungsform bildet oder daß auf dem Leiterrahmen die ringförmige Einfassung der anderen oben beschriebenen Ausführungsform geformt ist. Der Halbleiterkörper ist bei dieser Weiterbildung auf dem Leiterrahmen angebracht, wobei die elektrische Kontaktierung direkt (chip bonding) oder mittels Drahtverbindung (wire bonding) hergestellt sein kann. Diese sogenannte Leiterrahmentechnik wird vielfach bei strahlungsemittierenden Halbleiterbauelementen angewandt und kann mit Vorteil auch bei der vorliegenden Erfindung eingesetzt werden.

Zum Schutz des Halbleiterkörpers und des Lumineszenzkonversionselements kann die Ausnehmung mit einer strahlungsdurchlässigen Füllmasse, beispielsweise einer Vergußmasse, gefüllt sein. Vorzugsweise enthält diese Füllmasse ein Reaktionsharz, beispielsweise ein Acrylharz, ein Epoxidharz, ein Silikonharz oder eine Mischung dieser Harze. Durch eine geeignete Formgebung der Füllmasse kann eine Linsenwirkung oder eine Streuwirkung erzielt werden, die die Abstrahlungseigenschaften des erfindungsgemäßen Bauelements weiter verbessert oder wunschgemäß modifiziert. Auch kann es für automatische Bestückungsanlagen von Vorteil sein, mittels der Füllmasse bei dem Bauelement eine plane Oberfläche auszubilden, da solche Bauelemente von Bestückungsautomaten leichter aufgenommen und positioniert werden können (pick and place-Verfahren).

Bei einer aufgrund besonders einfacher Realisierbarkeit bevorzugten Ausführungsform besteht das Lumineszenzkonversionselement aus einem oder mehreren Leuchtstoffen, die in eine Matrix eingebettet sind. Als Matrix eignen sich hinsichtlich Mischbarkeit, Formbarkeit und Handhabung besonders Acrylharze, Epoxidharze und Silikonharze sowie Mischungen hiervon.

Als Leuchtstoff können einerseits organische Verbindungen wie beispielsweise Perylenfarbstoffe oder 4f-metallorganische Verbindungen eingemischt werden. So lassen sich Leuchtstoffe wie BASF Lumogen F083, Lumogen F240 und Lumogen F300 auf einfache Weise transparentem Epoxidharz zusetzen.

Ein weißer Gesamtfarbeindruck kann durch Verwendung von anorganischen Leuchtstoffen erreicht werden. Hierfür eigen sich insbesondere mit Seltenen Erden dotierte Granate sowie mit Seltenen Erden dotierte Erdalkalisulfide.

Effiziente Leuchtstoffe sind hierbei Verbindungen, die der Formel A₃B₅O₁₂:M genügen (sofern sie nicht unter den üblichen Herstellungs- und Betriebsbedingungen instabil sind). Darin bezeichnet A mindestens ein Element der Gruppe Y, Lu, Sc, La, Gd, Tb und Sm, B mindestens ein Element der Gruppe Al, Ga und In und M mindestens ein Element der Gruppe Ce und Pr, vorzugsweise Ce. Besonders bevorzugt sind hierbei als Leuchtstoff YAG:Ce (Y₃Al₅O₁₂:Ce³⁺), TbYAG:Ce ((YₓTb₁₋ₓ)₃Al₅O₁₂:Ce³⁺, 0≤x≤1), GdYAG:Ce ((GdₓY₁₋ₓ)₃Al₅O₁₂:Ce³⁺, 0<x<1), GdTbYAG:Ce ((GdₓTb_{y}Y_{1-x-y})₃Al₅O₁₂:Ce³, 0<x<1, 0<y<1) sowie hierauf basierende Gemische. Dabei kann Al zumindest teilweise durch Ga oder In ersetzt sein. Weiter bevorzugt sind die Verbindungen SrS:Ce³⁺,Na, SrS:Ce³⁺,Cl, SrS:CeCl₃, CaS:Ce³⁺, SrSe:Ce³⁺ und Y₃Ga₅O₁₂:Ce³⁺_{.}

Zur Erzeugung von verschiedenartig mischfarbigem Licht eignen sich mit Seltenen Erden dotierte Thiogallate wie beispielsweise CaGa₂S₄:Ce³⁺ oder SrGa₂S₄:Ce³⁺. Ebenso ist hierzu die Verwendung von mit Seltenen Erden dotierten Aluminaten wie beispielsweie YAlO₃:Ce³⁺ und YAl₁₋ₓGaₓO₃:Ce³⁺, 0≤x≤1 und mit Seltenen Erden dotierten Orthosilikaten M'₂SiO₅:Ce³⁺ (M':Sc,Y,La) wie beispielsweise Y₂SiO₅:Ce³⁺ denkbar. Bei allen Yttriumverbindungen kann Yttrium im Prinzip durch Scandium oder Lanthan ersetzt werden. Die jeweilige Zusammensetzung des Leuchtstoffs bestimmt sich dabei in erster Linie aus dem gewünschten Gesamtfarbeindruck sowie der Zentralwellenlängen des Primärlichts.

Bei einer weiteren besonders bevorzugten Ausführungsform werden als Matrix für das Lumineszenzkonversionselement und als Füllmasse in der Ausnehmung verschiedene Materialien verwendet. Dabei kann mit Vorteil für das Lumineszenzkonversionselement ein Material verwendet werden, daß hinsichtlich Mischbarkeit mit dem Leuchtstoff und Strahlungsbeständigkeit optimal ist, während für die Füllmasse ein Material gewählt wird, das sich aufgrund seiner Transparenz und seiner mechanischen Beständigkeit besonders eignet.

Durch diese zusätzliche Variationsmöglichkeit bei der Wahl der Füllmasse und Matrix des Lumineszenzkonversionselements können so vorteilhafterweise weitere Randbedingungen bei der Gestaltung eines strahlungsemittierenden Halbleiterbauelements mit Lumineszenzkonversionselement erfüllt werden.

Mit besonderem Vorteil können bei erfindungsgemäßen Bauelementen Halbleiterkörper verwendet werden, die Licht mit einer Zentralwellenlänge unter 460 nm abstrahlen. Die Verwendung solcher Halbleiterkörper ist bei den oben beschriebenen Bauelementen nach dem Stand der Technik nicht sinnvoll, da Licht in diesem Wellenlängenbereich die Füllmasse schädigen kann, so daß die Füllmasse dadurch sehr schnell altert. Dieser Nachteil ist bei erfindungsgemäßen Bauelementen gemindert, da ein Teil der Primärstrahlung sehr nahe am Halbleiterkörper konvertiert wird, so daß der Anteil der kurzwelligen Strahlung in der Füllmasse reduziert ist und insgesamt die Lebensdauer des Bauelements verlängert wird.

Bevorzugt wird als Matrix für das Lumineszenzkonversionselement ein Silikonharz verwendet, das sich durch eine besonders hohe Strahlungsbeständigkeit im grünen, blauen und ultravioletten Spektralbereich auszeichnet. Die Verwendung von Silikonharzen ist besonders vorteilhaft in Verbindung mit Halbleiterkörper, die Strahlung mit einer Wellenlänge unter 430 nm emittieren. Strahlung in diesem Spektralbereich kann bei anderen Harzen zu Strahlungsschäden führen, die die Lebensdauer des Bauelements deutlich reduzieren. Ein Lumineszenzkonversionselement mit einer Silikonharzmatix kann bei der Erfindung mit einer das Lumineszenzkonversionselement abdekkenden Füllmasse auf des Basis eines Epoxidharzes kombiniert werden. Epoxidharze zeichnen sich hierbei durch hohe Transparenz und mechanische Stabilität aus.

Mit besonderem Vorteil lassen sich mit erfindungsgemäßen Bauteilen Weißlichtleuchtdioden realisieren, wie sie in der oben genannten Druckschrift WO 97/50132 beschrieben sind. Leuchtstoff und Halbleiterkörper sind hier so aufeinander abgestimmt, daß die Farben von Primärlicht und Fluoreszenzlicht zueinander komplementär sind. Durch additive Farbmischung wird der Eindruck weißen Lichts hervorgerufen. Der Inhalt der Druckschriften WO 97/50132 und WO 98/12757 wird zum Inhalt dieser Beschreibung gemacht.

Eine Mehrzahl von beanspruchten Bauelementen kann zu größeren Beleuchtungseinheiten zusammengefügt werden. Solche Beleuchtungseinheiten, gegebenenfalls mit matrixartiger Anordnung der Bauelemente, zeichnen sich durch hohe Leuchtdichte und besonders homogenen Gesamtfarbeindruck aus.

Mit besonderem Vorteil eignen sich die erfindungsgemäßen Bauelemente als Lichtquellen in abbildenden Linsensystemen. Da Primär- und Fluoreszenzlicht aus räumlich eng benachbarten und etwa gleich großen Volumina abgestrahlt werden, sind die chromatischen Verzerrungen, die ein solches Linsensystem hervorruft, deutlich geringer als bei Lichtquellen nach dem oben genannten Stand der Technik. Weiterhin ist es daher vorteilhafterweise möglich, die Abstrahlungscharakteristik eines erfindungsgemäßen Bauelements mittels einer oder mehrerer Linsen ohne Veränderung des Gesamtfarbeindrucks zu modifizieren.

Ausgangspunkt des erfindungsgemäßen Herstellungsverfahrens für ein strahlungsemittierendes Halbleiterbauelement mit Lumineszenzkonversionselement stellt ein Grundkörper mit einer Ausnehmung dar, in dem ein Leiterrahmen eingebettet ist, so daß ein Teilbereich des Leiterrahmens die Bodenfläche der Ausnehmung bildet. Zunächst wird der Leiterrahmen mit einer Formmasse überspritzt, wobei der Chipanschlußbereich ausgespart wird. Diese Aussparung bildet den gesonderten Bereich zur Aufnahme des Lumineszenzkonversionselements. Danach wird der Halbleiterkörper auf den Chipanschlußbereich des Leiterrahmens montiert und es werden die für den Betrieb erforderlichen elektrischen Verbindungen zwischen Halbleiterkörper und Leiterrahmen hergestellt. Im nächsten Schritt wird der ausgesparte Bereich mit dem Lumineszenzkonversionselement gefüllt, wobei der Halbleiterkörper vollständig in das Lumineszenzkonversionselement eingebettet wird.

Bei einem weiteren erfindungsgemäßen Herstellungsverfahren wird ebenfalls als Ausgangsprodukt ein Grundkörper mit Ausnehmung verwendet, in dem ein Leiterrahmen so eingebettet ist, daß ein Teil des Leiterrahmens die Bodenfläche der Ausnehmung bildet. Auf dem Leiterrahmen wird um den Chipanschlußbereich herum mit einer Formmasse eine ringförmige Einfassung ausgebildet. Der Innenbereich dieser Einfassung bildet den gesonderten Bereich zur Aufnahme des Lumineszenzkonversionselements. Innerhalb dieser Einfassung wird auf dem Chipanschlußbereich des Leiterrahmens der Halbleiterkörper aufgebracht und es werden die für den Betrieb erforderlichen elektrischen Verbindungen zwischen Halbleiterkörper und Leiterrahmen hergestellt. Im nächsten Schritt wird die Einfassung mit dem Lumineszenzkonversionselement ausgefüllt, wobei der Halbleiterkörper vollständig in das Lumineszenzkonversionselement eingebettet wird.

Beide Verfahren besitzen den Vorteil, daß als Ausgangsmaterial Standardgehäuse beziehungsweise Grundkörper mit Standardgehäuseformen verwendet werden können. Die Ausformung des gesonderten Bereichs zur Aufnahme des Lumineszenzkonversionselements kann leicht in dem Herstellungsprozeß des erfindungsgemäßen Bauelements integriert werden.

Bei einer vorteilhaften Weitergestaltung der Erfindung wird die Ausnehmung mit einer strahlungsdurchlässigen Füllmasse, beispielsweise einer entsprechenden Vergußmasse, gefüllt. Da die Umhüllung des Halbleiterkörpers in zwei Schritten erfolgt, werden vorteilhafterweise Delamination des Halbleiterkörpers von der Umhüllung und Rissbildung in der Umhüllung vermindert und dadurch Feuchtebeständigkeit und Lebensdauer des Bauelements erhöht.

Im folgenden Text sind weitere Aspekte der vorliegenden Offenbarung beschrieben, wobei die einzelnen Aspekte nummeriert sind, um die Bezugnahme auf Merkmale anderer Aspekte zu erleichtern.
1. Strahlungsemittierendes Halbleiterbauelement mit einem Grundkörper, in dem eine Ausnehmung vorgesehen ist, mindestens einem Halbleiterkörper (3) und einem Lumineszenzkonversionselement (7), wobei die Ausnehmung einen napfartig ausgeformten Teilbereich aufweist, in dem der Halbleiterkörper (3) angeordnet ist und der mit dem Lumineszenzkonversionselement (7) gefüllt ist, wobei das Lumineszenzkonversionselement (7) eine Grenzfläche aufweist, die den napfartigen Teilbereich gegen den übrigen Innenraum der Ausnehmung abgrenzt.
2. Strahlungsemittierendes Halbleiterbauelement nach Aspekt 1,
   wobei der napfartige Teilbereich durch eine Vertiefung innerhalb der Ausnehmung geformt ist.
3. Strahlungsemittierendes Halbleiterbauelement nach Aspekt 2,
   wobei ein Leiterrahmen (2) in den Grundkörper (1) so eingebettet ist, daß ein Teilbereich des Leiterrahmens (2) die Bodenfläche der Vertiefung bildet.
4. Strahlungsemittierendes Halbleiterbauelement nach Aspekt 1,
   wobei der napfartige Teilbereich durch eine ringförmige Einfassung (6) auf dem Grund der Ausnehmung geformt ist.
5. Strahlungsemittierendes Halbleiterbauelement nach Aspekt 4,
   wobei ein Leiterrahmen (2) in den Grundkörper (1) eingebettet ist, so daß ein Teilbereich des Leiterrahmens (2) die Bodenfläche der Ausnehmung bildet und die ringförmige Einfassung (6) auf dem Leiterrahmen (2) ausgebildet ist.
6. Strahlungsemittierendes Halbleiterbauelement nach einem der Aspekte 1 bis 5,
   wobei der Grundkörper (1) mit der den napfartigen Teilbereich aufweisenden Ausnehmung einstückig gebildet ist.
7. Strahlungsemittierendes Halbleiterbauelement nach einem der Aspekte 1 bis 6,
   wobei der Grundkörper (1) mittels eines Spritzguß- oder eines Spritzpreßverfahrens gebildet ist.
8. Strahlungsemittierendes Halbleiterbauelement nach einem der Aspekte 2 bis 7,
   wobei die Seitenwände der Vertiefung beziehungsweise die Innenseite der ringförmigen Einfassung (6) als Reflektor dienen.
9. Strahlungsemittierendes Halbleiterbauelement nach einem der Aspekte 1 bis 8,
   wobei die Ausnehmung zumindest teilweise mit einer strahlungsdurchlässigen Füllmasse (13) gefüllt ist, die an das Lumineszenzkonversionselement (7) grenzt.
10. Strahlungsemittierendes Halbleiterbauelement nach Aspekt 9,
   wobei die Füllmasse (13) ein Reaktionsharz enthält ist.
11. Strahlungsemittierendes Halbleiterbauelement nach Aspekt 9 oder 10,
   wobei die Füllmasse (13) ein Acrylharz, ein Epoxidharz, ein Silikonharz oder eine Mischung dieser Harze enthält.
12. Strahlungsemittierendes Halbleiterbauelement nach einem der Aspekte 3 bis 11,
   wobei der Leiterrahmen (2) einen Chipanschlußbereich (12) und einen Drahtanschlußbereich (11) aufweist und daß der Halbleiterkörper auf dem Chipanschlußbereich (12) aufgebracht ist und mit dem Drahtanschlußbereich (11) durch eine Drahtverbindung (4) verbunden ist.
13. Strahlungsemittierendes Halbleiterbauelement nach einem der Aspekte 1 bis 12,
   wobei das Lumineszenzkonversionselement (7) mindestens einen organischen oder anorganischen Leuchtstoff enthält, der in eine Matrix eingebettet ist.
14. Strahlungsemittierendes Halbleiterbauelement Aspekt 13, wobei das Lumineszenzkonversionselement (7) YAG:Ce, TbYAG:Ce, GdYAG:Ce, GdTbYAG:Ce oder hierauf basierende Gemische enthält, wobei Al zumindest teilweise durch Ga oder In ersetzt sein kann.
15. Strahlungsemittierendes Halbleiterbauelement nach Aspekt 13 oder 14,
   wobei die Matrix ein Reaktionsharz enthält.
16. Strahlungsemittierendes Halbleiterbauelement nach einem der Aspekte 13 bis 15,
   wobei die Matrix ein Acrylharz, Epoxidharz oder Silikonharz oder eine Mischung dieser Harze enthält.
17. Strahlungsemittierendes Halbleiterbauelement nach einem der Aspekte 13 bis 16,
   wobei die Füllung der Ausnehmung und die Matrix des Lumineszenzkonversionselements (7) verschiedene Zusammensetzungen aufweisen.
18. Strahlungsemittierendes Halbleiterbauelement nach Aspekt 13 bis 17,
   wobei die Ausnehmung mit einer ein Epoxidharz enthaltenden Füllmasse (13) gefüllt ist und die Matrix ein Silikonharz enthält.
19. Strahlungsemittierendes Halbleiterbauelement nach einem der Aspekte 1 bis 18,
   wobei die Zentralwellenlänge der von dem Halbleiterkörper (3) im Betrieb emittierten Strahlung unter 460 nm liegt.
20. Strahlungsemittierendes Halbleiterbauelement nach einem der Aspekte 1 bis 19,
   wobei die Farbe der von dem Halbleiterkörper (3) im Betrieb emittierten Strahlung und die Farbe des von dem Lumineszenzkonverisonselement (7) emittierten Lichts zueinander komplementär sind, so daß der Eindruck weißen Lichts hervorgerufen wird.
21. Verfahren zur Herstellung eines strahlungsemittierenden Halbleiterbauelements mit Lumineszenzkonversionselement (7) mit den Schritten
   - Herstellen eines Grundkörpers (1) mit einer Ausnehmung und einem eingebetteten Leiterrahmen (2),
   - Überspritzen des Leiterrahmens (2) mit einer Formmasse, wobei der Chipanschlußbereich (12) des Leiterrahmens (2) zur Bildung eines napfartigen Teilbereichs ausgespart wird,
   - Aufbringen eines Halbleiterkörpers (3) auf den Chipanschlußbereich (12) und Kontaktieren des Halbleiterkörpers (3),
   - Füllen des napfartigen Teilbereichs über dem Chipanschlußbereich (12) mit dem Lumineszenzkonversionselement (7) derart, daß eine Grenzfläche des Lumineszenzkonversionselements (7) den napfartigen Teilbereich gegen den übrigen Innenraum der Ausnehmung abgrenzt.
22. Verfahren zur Herstellung eines strahlungsemittierenden Halbleiterbauelements mit Lumineszenzkonversionselement mit den Schritten
   - Herstellen eines Grundkörpers (1) mit Ausnehmung und eingebettetem Leiterrahmen (2),
   - Ausbilden einer ringförmigen Einfassung (6) um den Chipanschlußbereich (12) ) zur Formung eines napfartigen Teilbereichs,
   - Aufbringen eines Halbleiterkörpers (3) auf den Chipanschlußbereich (12) und Kontaktierung des Halbleiterkörpers (3),
   - Füllen des Innenbereichs der Einfassung (6) mit dem Lumineszenzkonversionselement (7).
23. Verfahren nach Aspekt 22,
   wobei der Innenbereich der Einfassung derart mit dem Lumineszenzkonversionselement (7) gefüllt wird, daß eine Grenzfläche des Lumineszenzkonversionselements (7) den napfartigen Teilbereich gegen den übrigen Innenraum der Ausnehmung abgrenzt.
24. Verfahren nach einem der Aspekte 21 bis 23,
   wobei der Grundkörper mittels eine Spritzguß- oder Spritzpreßverfahrens hergestellt wird.
25. Verfahren nach einem der Aspekte 21 bis 24,
   wobei die Ausnehmung mit einer strahlungsdurchlässigen Füllmasse (13) gefüllt wird.
26. Verwendung einer Mehrzahl von strahlungsemittierenden Halbleiterbauelementen nach einem der Aspekte 1 bis 20 in einer LED-Beleuchtungseinheit.
27. Verwendung einer Mehrzahl von strahlungsemittierenden Halbleiterbauelementen nach einem der Aspekte 1 bis 20 in einer LED-Beleuchtungseinheit, in der die strahlungsemittierenden Halbleiterbauelemente nach einem der Aspekte 1 bis 18 matrixartig angeordnet sind.
28. Verwendung eines strahlungsemittierenden Halbleiterbauelements nach einem der Aspekte 1 bis 20 als Lichtquelle in einer abbildenden Optik.

Weitere Merkmale und Vorteile ergeben sich aus der nachfolgenden Beschreibung von vier Ausführungsbeispielen in Verbindung mit den Figuren 1 bis 4.

Es zeigen:
Figur 1 eine schematische Schnittansicht eines ersten Ausführungsbeispiels eines erfindungsgemäßen strahlungsemittierenden Halbleiterbauelements mit Lumineszenzkonversionselement,
Figur 2 eine schematische Schnittansicht eines zweiten Ausführungsbeispiels eines erfindungsgemäßen strahlungsemittierenden Halbleiterbauelements mit Lumineszenzkonversionselement,
Figur 3 eine schematische Darstellung eines ersten Ausführungsbeispiels eines erfindungsgemäßen Herstellungsverfahrens und
Figur 4 eine schematische Darstellung eines zweiten Ausführungsbeispiels eines erfindungsgemäßen Herstellungsverfahrens.

In den verschiedenen Figuren sind gleiche beziehungsweise gleichwirkende Teile mit demselben Bezugszeichen versehen.

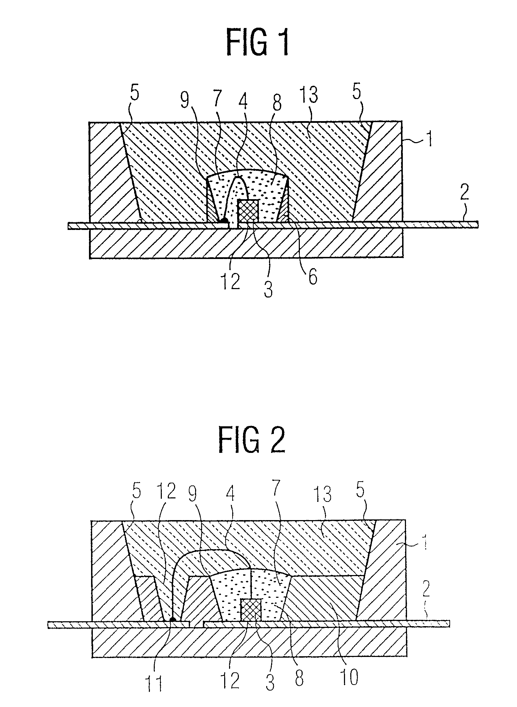

Das in Figur 1 gezeigte erfindungsgemäße Halbleiterbauelement besitzt als Grundkörper 1 ein Standardgehäuse. Dies kann beispielsweise ein oberflächenmontierbares LED-Gehäuse sein, das aus einem Thermoplast besteht. Die Seitenwände 5 sind leicht angeschrägt und wirken als Reflektor für die erzeugte Strahlung. In den Grundkörper 1 ist ein Leiterrahmen 2 integriert. Auf den Chipanschlußbereich 12 des Leiterrahmens 2 ist der Halbleiterkörper 3 gebondet und über eine Drahtverbindung 4 mit dem Drahtanschlußbereich 11 des Leiterrahmens 2 elektrisch verbunden. Je nach Gestaltung des Halbleiterkörpers kann die Kontaktierung des Halbleiterkörpers 3 auch über mehrere Drahtverbindungen erfolgen.

Um den Halbleiterkörper 3 herum ist ein kleinerer Reflektorring 6 ausgebildet. Vorzugsweise kann als Material für diesen Reflektorring ebenfalls ein Thermoplast verwendet werden. Der Reflektorring 6 ist mit dem Lumineszenzkonversionselement gefüllt, das aus einer Suspension des Leuchtstoffs 8 in einer Matrix wie beispielsweise Silikon besteht. Silikon eignet sich aufgrund seiner Alterungsstabilität insbesondere bei der Verwendung kurzwellig (blau, UV) emittierender Halbleiterkörper 3.

Als Bauhöhe des Reflektorrings 6 haben sich Maße zwischen 0,3 mm und 0,7 mm als besonders vorteilhaft erwiesen. Reflektoren dieser Größe gewährleisten einerseits eine vollständige Einhüllung des Halbleiterkörpers 3 mit dem Lumineszenzkonversionselement 7, ohne andererseits das Volumen des Lumineszenzkonversionselements 7 unnötig zu vergrößern.

Hierbei ist es von besonderem Vorteil, den Reflektorring 6 mit scharfen Kanten 9 auszubilden. Dies bewirkt, daß bei der Befüllung des Reflektorrings 6 die Leuchtstoffsuspension aufgrund ihrer Oberflächenspannung eine Kuppe über dem Reflektorring 6 ausbildet, wodurch weitergehend die vollständige Einbettung des Halbleiterkörpers 3 in das Lumineszenzkonversionselement 7 sichergestellt wird.

Der verbleibende Teil der Ausnehmung ist mit einem transparentem Verguß 13 wie beispielsweise Epoxidharz gefüllt.

Das in Figur 2 gezeigte erfindungsgemäße Halbleiterbauelement unterscheidet sich von dem in Figur 1 gezeigten Bauelement darin, daß der Bereich um den Halbleiterkörper 3 zur Aufnahme des Lumineszenzkonversionselements 7 durch eine Vertiefung über den Chipanschlußbereich 12 des Leiterrahmens 2 ausgebildet ist. Dazu ist der Leiterrahmen 2 von einer dünnen Formmasseschicht 10 (Höhe vorzugsweise ebenfalls 0,3 mm bis 0,7 mm) bedeckt, wobei die Vertiefung durch eine Aussparung der Formmasseschicht 10 über dem Chipanschlußbereich 12 gebildet ist. Wie im vorangehend beschriebenen Ausführungsbeispiel kann eine Ausführung der Aussparung mit scharfen Kanten 9 zur Ausbildung einer Kuppe des Lumineszenzkonversionselements 7 über dem Halbleiterkörper 3 vorteilhaft sein. Der von der Formmasse ausgesparte Bereich um den Halbleiterkörper 3 herum ist mit dem Lumineszenzkonversionselement 7 gefüllt.

Bei dem gezeigten Ausführungsbeispiel ist weiterhin der Drahtanschlußbereich 11 von der Formmasseschicht 10 ausgespart. Diese Aussparung ist so gestaltet, daß die Seitenflächen der Aussparung von den Gehäuseseitenflächen 5 abgesetzt sind. Dies verhindert, daß Teile der Leuchtstoffsuspension, die bei der Herstellung in die Aussparung über dem Drahtanschlußbereich 11 eindringen können, an der Gehäusewand 5 hinauffließen. Dieses Hinauffließen wird unter anderem durch die Rauhigkeit der Gehäusewand 5 begünstigt und ist unerwünscht, da dadurch der Abstrahlungsbereich des Fluoreszenzlichts vergrößert wird.

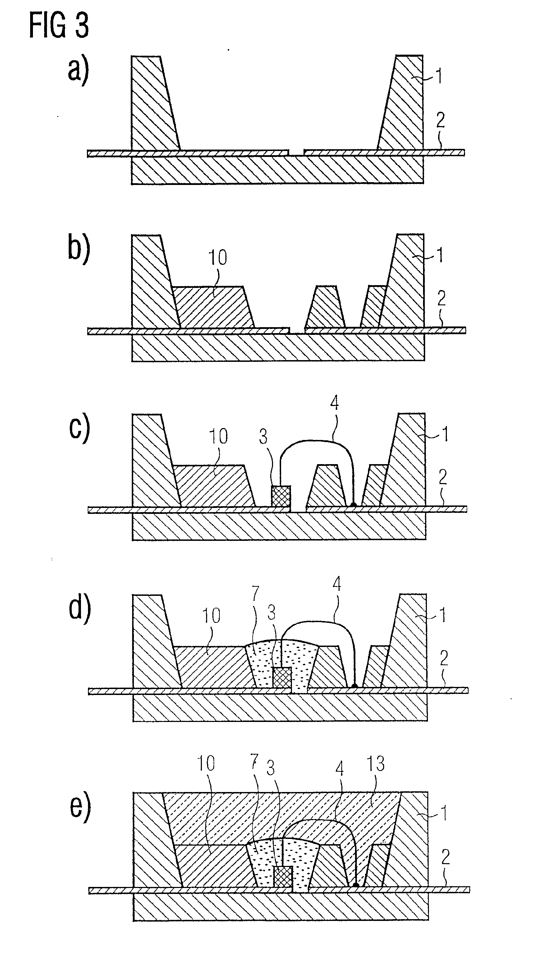

In Figur 3 ist schematisch ein Ausführungsbeispiel eines erfindungsgemäßen Herstellungsverfahrens gezeigt. Im ersten Schritt wird der Grundkörper 1 mit Ausnehmung und intergriertem Leiterrahmen 2 hergestellt, Figur 3a, beispielsweise durch Umspritzen des Leiterrahmens 2 mit der Gehäuseformmasse in einem Spritzgußverfahren.

Im nächsten Schritt wird der Leiterrahmen 2 mit der Formmasse, beispielsweise PPA, überspritzt, so daß der Leiterrahmen 2 von eine Formmasseschicht 10 mit gleichbleibender Dicke abgedeckt wird. Der Chipanschlußbereich 12 und der Drahtanschlußbereich 11 des Leiterrahmens 2 wird dabei freigehalten, Figur 3b. Alternativ kann die in Figur 3b gezeigte Gehäuseform natürlich auch in einem einzigen Verfahrensschritt hergestellt werden.

Daraufhin wird der Halbleiterkörper 3 auf den Chipanschlußbereich 12 gebondet und die Drahtverbindung 4 zwischen Halbleiterkörper 3 und Leiterrahmen 2 hergestellt, Figur 3c. Nach Abschluß des Bondings wird die Aussparung um den Halbleiterkörper 3 mit dem Lumineszenzkonversionselement 7, beispielsweise einer Suspension eines Leuchtstoffs in einem Kunstharz gefüllt, Figur 3d.

Abschließend kann ein Verguß 13 des Bauelements mit einem strahlungsdurchlässigen Material wie beispielsweise Epoxidharz erfolgen, Figur 3e. Je nach Anforderung an das Bauelement kann die Oberfläche des Vergusses plan, linsenartig, genoppt oder als Streuscheibe ausgeführt werden.

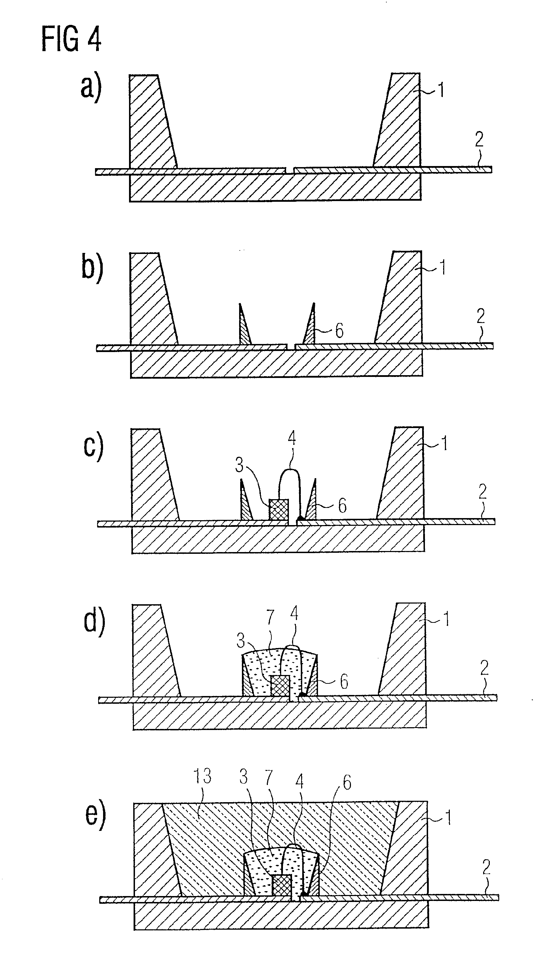

Bei dem in Figur 4 gezeigten Ausführungsbeispiel eines erfindungsgemäßen Herstellungsverfahrens wird im ersten Schritt ebenfalls der Grundkörper 1 mit Ausnehmung und eingebettetem Leiterrahmen 2 hergestellt, Figur 4a.

Danach wird ein den Chipanschlußbereich 12 umgebender Reflektorring 6 auf den Leiterrahmen 2 aufgespritzt, Figur 4b. Auch hier kann die Herstellung des Grundkörpers 1 und des Reflektorrings 6 in einem einzigen Herstellungsschritt erfolgen. Der Halbleiterkörper 3 wird daraufhin auf den Chipanschlußbereich 12 des Leiterrahmens 2 montiert und kontaktiert, Figur 4c. Im nächsten Schritt wird der Reflektorring 6 mit dem Lumineszenzkonversionselement 7 in Form einer Leuchtstoffsuspension gefüllt, wobei sich aufgrund der scharfkantigen Berandung 9 des Reflektorrings 6 und der Oberflächenspannung der Leuchtstoffsuspension eine Kuppe über dem Halbleiterkörper 3 ausbildet, Figur 4d. Dadurch wird eine vollständige Umhüllung des Halbleiterkörpers 3 gewährleistet, ohne das Volumen des Lumineszenzkonversionselements 7 unnötig zu vergrößern.

Wie im vorangegangenen Ausführungsbeispiel kann danach das Bauelement vergossen werden, Figur 4e.

Die Erläuterung der Erfindung anhand der oben beschriebenen Ausführungsbeispiele ist natürlich nicht als Beschränkung der Erfindung zu verstehen.

## Patentansprüche

1. Strahlungsemittierendes Halbleiterbauelement mit einem Grundkörper (1), in dem eine Ausnehmung vorgesehen ist, mindestens einem Halbleiterkörper (3) und einem Lumineszenzkonversionselement (7),
wobei
die Ausnehmung einen napfartig ausgeformten Teilbereich aufweist, in dem der Halbleiterkörper (3) angeordnet ist und der mit dem Lumineszenzkonversionselement (7) gefüllt ist, und wobei das Lumineszenzkonversionselement (7) eine Grenzfläche aufweist, die den napfartigen Teilbereich gegen den übrigen Innenraum der Ausnehmung abgrenzt.

2. Strahlungsemittierendes Halbleiterbauelement nach Anspruch 1,
wobei die Ausnehmung zumindest teilweise mit einer strahlungsdurchlässigen Füllmasse (13) gefüllt ist, die an das Lumineszenzkonversionselement (7) grenzt und wobei eine Oberfläche der Füllmasse (13) linsenartig ausgeführt ist.

3. Strahlungsemittierendes Halbleiterbauelement nach Anspruch 1 oder 2,
wobei
der napfartige Teilbereich durch eine Vertiefung innerhalb der Ausnehmung geformt ist.

4. Strahlungsemittierendes Halbleiterbauelement nach Anspruch 3,
wobei
ein Leiterrahmen (2) in den Grundkörper (1) so eingebettet ist, daß ein Teilbereich des Leiterrahmens (2) die Bodenfläche der Vertiefung bildet.

5. Strahlungsemittierendes Halbleiterbauelement nach Anspruch 1 oder 2,
wobei
der napfartige Teilbereich durch eine ringförmige Einfassung (6) auf dem Grund der Ausnehmung geformt ist.

6. Strahlungsemittierendes Halbleiterbauelement nach Anspruch 5,
wobei
ein Leiterrahmen (2) in den Grundkörper (1) eingebettet ist, so daß ein Teilbereich des Leiterrahmens (2) die Bodenfläche der Ausnehmung bildet und die ringförmige Einfassung (6) auf dem Leiterrahmen (2) ausgebildet ist.

7. Strahlungsemittierendes Halbleiterbauelement nach einem der Ansprüche 1 bis 6,
wobei
der Grundkörper (1) mit der den napfartigen Teilbereich aufweisenden Ausnehmung einstückig gebildet ist.

8. Strahlungsemittierendes Halbleiterbauelement nach einem der Ansprüche 3 bis 7,
wobei
die Seitenwände der Vertiefung beziehungsweise die Innenseite der ringförmigen Einfassung (6) als Reflektor dienen.

9. Strahlungsemittierendes Halbleiterbauelement nach einem der Ansprüche 4 bis 8,
wobei
der Leiterrahmen (2) einen Chipanschlußbereich (12) und einen Drahtanschlußbereich (11) aufweist und der Halbleiterkörper auf dem Chipanschlußbereich (12) aufgebracht ist und mit dem Drahtanschlußbereich (11) durch eine Drahtverbindung (4) verbunden ist.

10. Strahlungsemittierendes Halbleiterbauelement nach Anspruch 2 oder einen auf Anspruch 2 rückbezogenen Anspruch,
wobei
das Lumineszenzkonversionselement (7) mindestens einen organischen oder anorganischen Leuchtstoff enthält, der in eine Matrix eingebettet ist und wobei die Füllung der Ausnehmung und die Matrix des Lumineszenzkonversionselements (7) verschiedene Zusammensetzungen aufweisen.

11. Verfahren zur Herstellung eines strahlungsemittierenden Halbleiterbauelements mit einem Lumineszenzkonversionselement (7) und einem Grundkörper (1) mit einer Ausnehmung und einem eingebetteten Leiterrahmen (2) mit den Schritten
- Überspritzen des Leiterrahmens (2) mit einer Formmasse, wobei ein Chipanschlußbereich (12) des Leiterrahmens (2) zur Bildung eines napfartigen Teilbereichs ausgespart wird,
- Aufbringen eines Halbleiterkörpers (3) auf den Chipanschlußbereich (12) und Kontaktieren des Halbleiterkörpers (3),
- Füllen des napfartigen Teilbereichs über dem Chipanschlußbereich (12) mit dem Lumineszenzkonversionselement (7) derart, daß eine Grenzfläche des Lumineszenzkonversionselements (7) den napfartigen Teilbereich gegen den übrigen Innenraum der Ausnehmung abgrenzt;
wobei
der Grundkörper (1) mit der Ausnehmung mittels eines Spritzguß- oder eines Spritzpreßverfahrens hergestellt wird.

12. Verfahren zur Herstellung eines strahlungsemittierenden Halbleiterbauelements mit einem Lumineszenzkonversionselement (7) und einem Grundkörper (1) mit einer Ausnehmung und einem eingebetteten Leiterrahmen (2) mit den Schritten
- Ausbilden einer ringförmigen Einfassung (6) um den Chipanschlußbereich (12) ) zur Formung eines napfartigen Teilbereichs,
- Aufbringen eines Halbleiterkörpers (3) auf den Chipanschlußbereich (12) und Kontaktierung des Halbleiterkörpers (3),
- Füllen des Innenbereichs der Einfassung (6) mit dem Lumineszenzkonversionselement (7);
wobei
der Grundkörper (1) mit der Ausnehmung mittels eines Spritzguß- oder eines Spritzpreßverfahrens hergestellt wird.

13. Verfahren nach Anspruch 11 oder 12,
wobei
der Innenbereich der Einfassung derart mit dem Lumineszenzkonversionselement (7) gefüllt wird, daß eine Grenzfläche des Lumineszenzkonversionselements (7) den napfartigen Teilbereich gegen den übrigen Innenraum der Ausnehmung abgrenzt.

14. Verfahren nach einem der Ansprüche 11 bis 13,
wobei
die Ausnehmung mit einer strahlungsdurchlässigen Füllmasse (13) gefüllt wird.

15. Verwendung einer Mehrzahl von strahlungsemittierenden Halbleiterbauelementen nach einem der Ansprüche 1 bis 14 in einer LED-Beleuchtungseinheit oder als Lichtquelle in einer abbilden Optik.
